# EUROPEAN PATENT APPLICATION

(11) **EP 1 204 141 A2**
(43) Date of publication of application: **08.05.2002**
(21) Application number: 01126114.6
(22) Date of filing: 02.11.2001
(51) Int. Cl.: H01L 21/768

(54) **Method for forming interconnects and semiconductor device**

(30) Priority: 02.11.2000 JP 2000335585
(71) Applicant: EBARA CORPORATION, Ohta-ku, Tokyo (JP)
(72) Inventor: Inoue, Hiroaki, Machida-shi, Tokyo (JP); Mishima, Koji, Fujisawa-shi, Kanagawa-ken (JP); Kato, Takao, Tokyo (JP); Nakamura, Kenji, Fujisawa-shi, Kanagawa-ken (JP); Matsumoto, Moriji, Fujisawa-shi, Kanagawa-ken (JP)
(74) Representative: Wagner, Karl H., Dipl.-Ing.

(57) **Abstract**

There is provided a method for forming interconnects by filling a conductive metal into fine recesses formed in the surface of a substrate, comprising: forming an underlying film on the surface of the substrate, the film comprising at least two kinds of metals; and conducting wet plating of the conductive metal onto the surface of the underlying film. The method can form a defect-free, completely embedded interconnects of a conductive material in recesses, even when the recesses are of a high aspect ratio.

## Description

### BACKGROUND OF THE INVENTION

### Field of the Invention:

This invention relates to a method for forming interconnects and a semiconductor device, and more particularly to a method for forming interconnects by filling a conductive metal, such as copper (Cu), into fine recesses for interconnects formed in the surface of a substrate, such as a semiconductor substrate, and to a semiconductor device having the interconnects formed by the method.

### Description of the Related Art:

In recent years, instead of aluminum or aluminum alloys generally used as a material for forming interconnection circuits on a semiconductor substrate, there is an eminent movement towards using copper. This is because the electric resistance of copper, which is 1.72µΩcm, is about 40% lower than the electric resistance of aluminum, and therefore copper interconnects less suffer from the signal delay phenomenon. Further, copper has a much higher electromigration resistance than aluminum, and is easier for use in dual-damascene processes. Thus, the use of copper offers a higher possibility of providing a complicated, fine multilayer interconnection structure at a relatively low production cost.

In dual-damascene processes, filling a metal, such as copper, simultaneously into trenches for interconnects and via holes, can be performed by any of the following techniques: ①CVD, ② sputtering and ③ plating. Of these techniques, the plating method ensures relatively good metal filling into fine recesses, and enables the formation of an interconnection circuit having a good conductivity by a relatively easy, low-cost process. Accordingly, it is now becoming a common practice to incorporate such a plating process into semiconductor mass production lines at least in the 0.18 µm design rule generation.

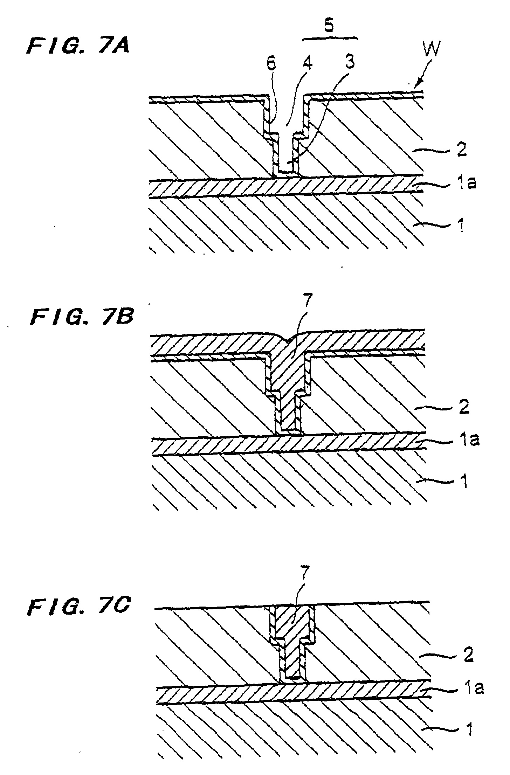

FIGS. 7A through 7C illustrate the basic process of an interconnects-forming method which can be used for performing copper plating onto the surface of a semiconductor substrate to obtain a semiconductor device having copper interconnects. As shown in FIG. 7A, in a semiconductor substrate W, an insulating film 2 of SiO₂ is deposited on a conductive layer 1a formed on a semiconductor base 1 bearing semiconductor devices. A fine recess 5 consisting of a contact hole 3 and a trench 4 for interconnects is formed in the insulating film 2 by the lithography/etching technique. Thereafter, a diffusion-inhibiting (barrier) layer 6 of TaN or the like is formed on the entire surface.

Thereafter, as shown in FIG. 7B, copper plating is performed onto the surface of the semiconductor substrate W to fill the recess (hole) 5 with copper 7 and, at the same time, deposit copper 7 on the diffusion-inhibiting (barrier) layer 6. Thereafter, the copper 7 on the diffusion-inhibiting (barrier) layer 6 as well as the diffusion-inhibiting (barrier) layer 6 are removed by chemical mechanical polishing (CMP) so as to make the surface of the copper 7 filled into the contact hole 3 and the trench 4 for interconnects and the surface of the insulating film 2 lie substantially on the same plane. An embedded interconnect composed of copper 7, as shown in FIG. 7C, is thus formed.

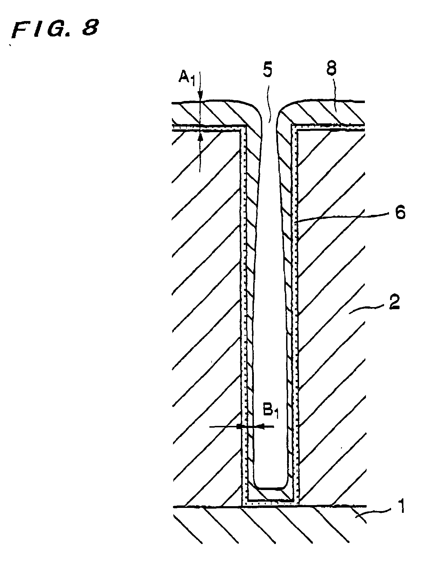

In the case where filling copper 7 into the fine recess 5 formed in the surface of the semiconductor substrate W is performed by electroplating, it is widely practiced to form, in advance of the copper plating, an underlying film (liner) 8 composed of copper or the like, which acts as an electric supply layer (seed layer), on the surface of the diffusion-inhibiting layer 6 formed on the semiconductor substrate W by sputtering, CVD, etc., as shown in FIG. 8. The main object of the underlying film (seed layer) 8 is to supply a sufficient electric current for reducing metal ions in a plating liquid and depositing the metal as a solid, by making the surface of the seed layer electrically cathodic. In the case where electroless plating is conducted for filling with copper, provision of a catalyst layer, instead of the electric supply layer, is widely practiced.

With the recent trend towards highly densified of interconnects, finer embedded interconnection structure, the aspect ratios of contact holes and of via holes are becoming higher. This poses various problems in the formation of underlying film 8 by sputtering, CVD, etc. Thus, when the underlying film 8, composed of e.g. copper, is formed in the recess (hole) 5 having a diameter of e.g. 0.15 µm and an aspect ratio of e.g. about 6, as shown in FIG. 8, the ratio of the film thickness B₁ of the underlying film 8 formed on the side wall of the recess 5 to the film thickness A₁ of the same film formed on the surface of the substrate W, i.e. B₁ /A₁ (side coverage), becomes as low as 5-10%. In addition, formation of a continuous layer of underlying film 8 becomes difficult. This is considered to be partly due to agglomeration of sputtered copper atoms upon the film formation, for example.

When a wet plating, e.g. electroplating or electroless plating, is performed onto such an underlying film to form copper interconnects, there is a problem that the seed layer may disappear due to etching by a plating liquid, leading to a failure of sufficient electric supply by the seed layer in the case of electroplating, for example, whereby electrodeposition of copper becomes insufficient to lower the yield. If the film thickness A of the seed layer, corresponding to the underlying film 8 of FIG. 8, is made larger for the purpose of obtaining an adequate side coverage, the aspect ratio is substantially increased, and clogging at the opening of the hole can occur upon the metal filling into thereby form voids in the hole, whereby the yield is lowered.

### SUMMARY OF THE INVENTION

The present invention has been made in view of the above problems in the related art. It is therefore an object of the present invention to provide a method for forming interconnects which can form a defect-free, completely embedded interconnects of a conductive material in recesses, even when the recesses are of a high aspect ratio, and to provide a semiconductor device having the interconnects formed by the method.

In order to achieve the above object, the present invention provides a method for forming an interconnect by filling a conductive metal into a fine recess formed in a surface of a substrate, comprising: forming an underlying film on the surface of the substrate, the underlying film comprising at least two kinds of metals; and performing wet plating of the conductive metal onto the surface of the underlying film.

This method can form a defect-free, completely embedded interconnects of a conductive material in recesses, even when the recesses are of a high aspect ratio. This is considered to be due to an improved side coverage properties of the underlying film, which may be caused by re-sputtering of metal particles having a large atomic weight at the upper and bottom portions of recesses and by suppression of agglomeration of metal particles having a small atomic weight by the action of the metal particles having a large atomic weight, and also to an enhanced etching resistance of the underlying film due to the presence therein of the metal particles having a large atomic weight.

According to a preferred embodiment of the present invention, the metals constituting the underlying film comprise a combination of a first metal, which is the same metal as the conductive metal, and a second metal, which is a noble metal having a larger atomic weight than the first metal. Thus, when copper is used as a material for interconnects, for example, copper is used as the first metal, and palladium, silver, platinum or gold is used as the second metal. The provision of an underlying film composed of such a combination of metals enables the formation of defect-less, completely embedded copper interconnects by the wet copper plating to fill the recesses of a substrate with copper, even when the recesses are of a high aspect ratio.

It is preferred to use gold, silver or copper as the first metal. This enables the formation of interconnects composed of the metal which have a lower interconnection resistance and higher electro migration resistance than aluminum interconnects.

It is especially preferred to use copper as the first metal, and palladium, silver, platinum or gold as the second metal.

The underlying film may be formed by sputtering or CVD.

The present invention also provides a semiconductor device, comprising: an underlying film formed in a fine recess formed in a surface of a substrate, the underlying film comprising at least two kinds of metals; and an interconnect of a conductive metal, which is deposited onto the underlying film by performing wet plating.

The present invention further provides an apparatus for forming an interconnect, comprising: a film-forming device for forming an underlying film on a surface of a substrate having a fine recess for an interconnect, the underlying film comprising at least two kinds of metals; and a plating device for performing wet plating of a conductive metal onto the underlying film, thereby filling the recess with the conductive metal.

The above and other objects, features, and advantages of the present invention will be apparent from the following description when taken in conjunction with the accompanying drawings which illustrates preferred embodiments of the present invention by way of example.

### BRIEF DESCRIPTION OF THE DRAWINGS

FIGS. 1A through 1D are diagrams illustrating, in a sequence of process steps, a method for forming interconnects in accordance with the present invention;
FIG. 2 is a plan view of an apparatus for forming interconnects in accordance with the present invention;
FIG. 3 is an imitated diagram of SEM photograph showing a section of a substrate which has undergone electrolytic copper plating as described in Example 1;
FIG. 4 is an imitated diagram of SEM photograph showing a section of a substrate which has undergone electroless copper plating as described in Example 2;
FIG. 5 is an imitated diagram of SEM photograph showing a section of a substrate which has undergone electrolytic copper plating as described in Comp. Example 1;
FIG. 6 is an imitated diagram of SEM photograph showing a section of a substrate which has undergone electroless copper plating as described in Comp. Example 2;
FIGS. 7A through 7C are diagrams illustrating, in a sequence of process steps, a basic method for forming interconnects by plating the surface of a semiconductor substrate; and
FIG. 8 is a cross-sectional view showing the state of a recess (hole) having a high aspect ratio when an underlying film (seed layer) is formed on the surface of the recess by a conventional method.

### DETAILED DESCRIPTION OF THE PREFERRED EMBODIMENTS

Preferred embodiments of the present invention will now be described with reference to the drawings.

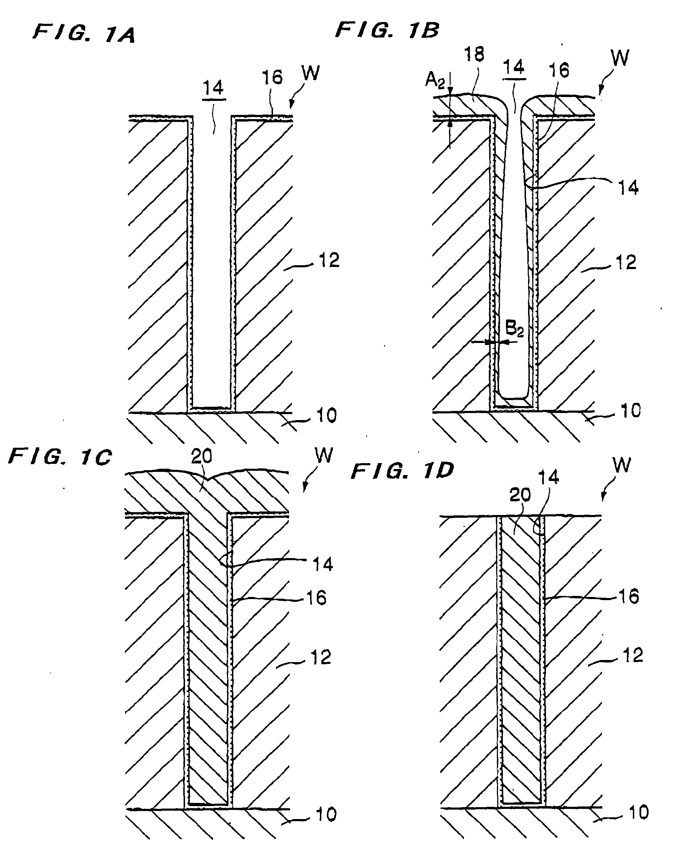

FIGS. 1A through 1D illustrate, in a sequence of process steps, a method for forming interconnects according to the present invention.

According to this embodiment, as shown in FIG. 1A, a substrate W composed of a semiconductor base 10 bearing semiconductor devices and an insulating film 12 of SiO₂ deposited on the semiconductor base 10, is subjected to lithography/etching processing to form fine recesses (holes) 14 for interconnects having a diameter of about 0.15 µm and an aspect ratio of about 6. Thereafter, copper is filled into the recesses 14 by performing wet plating (electroplating or electroless plating) to form copper interconnects.

More specifically, a diffusion-inhibiting (barrier) layer 16 of e.g. TaN is first formed on the surface of the substrate W by e.g. sputtering, as shown in FIG. 1A.

Thereafter, as shown in FIG. 1B, an underlying film 18, which acts as an electric supply (seed) layer or as a catalyst layer, is formed on the surface of the diffusion-inhibiting layer 16 by sputtering, CVD, etc. As a material for the underlying film 18, an alloy is herein used which consists of copper, which is the same material as the material for interconnects, and a noble metal having a high atomic weight than copper, e.g., palladium, silver, platinum or gold. A copper alloy containing 10 at % of palladium, Cu-Pd (10 at %), may be mentioned as a specific example of such an alloy. The content of palladium, silver, platinum or gold in the copper alloy is preferably in the range of 0.001 at % to 30 at %, more preferably in the range of 0.001 at % to 10 at %.

When the underlying film 18 is formed by using the Cu-Pd (10 at %) alloy, the ratio of the film thickness B₂ of the underlying film 18 formed on the side wall of the recess 14 to the film thickness A₂ of the same film formed on the surface of the substrate W, B₂/A₂ (side coverage), becomes higher than the side coverage B₁/A₁ of the conventional underlying film 8 formed solely of copper, as described above by referring to FIG. 8, indicating improved coverage properties of the former underlying film 18. Further, the underlying film 18 can be formed as a continuous layer.

The improvement in side coverage is considered to be due to re-sputtering of palladium particles, having larger atomic weight than copper, at the upper and bottom portions of the recess (contact hole or via hole) having high aspect ratio 14, leading to increased deposition of the underlying film, and also to suppression of agglomeration of copper particles, having smaller atomic weight, by the action of palladium particles having larger atomic weight than copper.

Next, as shown in FIG. 1C, wet copper plating (electroplating or electroless plating) is performed onto the surface of the semiconductor substrate W to fill the recess 14 with copper 20 and, at the same time, deposite copper 20 on the diffusion-inhibiting (barrier) layer 16, whereby copper 20 can be filled into the recess 14 without any defects such as voids and seals.

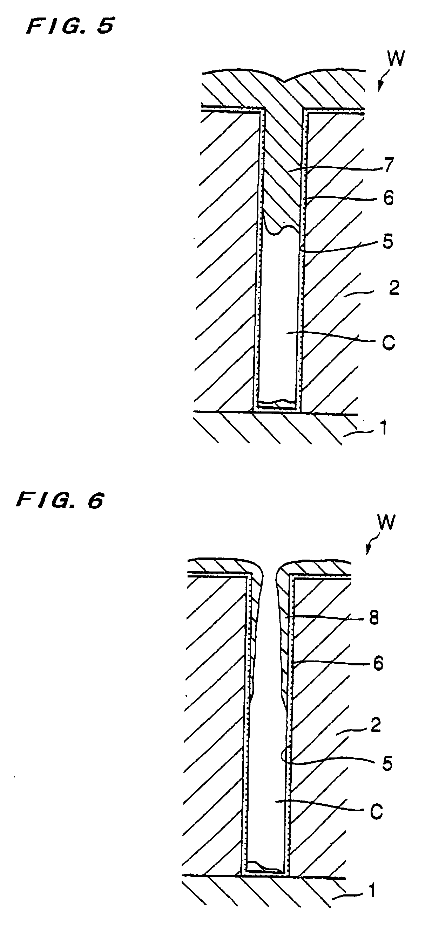

This may be due to the above-described improved coverage properties of the underlying film 18 and also to enhanced etching resistance of the underlying film 18, compared to the conventional underlying film 8 composed solely of copper (FIG. 6), which may be caused by the presence of palladium having larger atomic weight than copper. Thus, etching of the underlying film 18 by a plating liquid is suppressed.

Thereafter, as shown in FIG. 1D, copper 20 on the diffusion-inhibiting (barrier) layer 16 as well as the diffusion- inhibiting (barrier) layer 16 are removed by chemical mechanical polishing (CMP) so as to make the surface of the copper 20 filled into the recess 14 and the surface of the insulating film 12 lie substantially on the same plane, whereby a defect-free, completely embedded interconnects composed of copper 20 is formed in the recess 14, even though the recess 14 is of high aspect ratio.

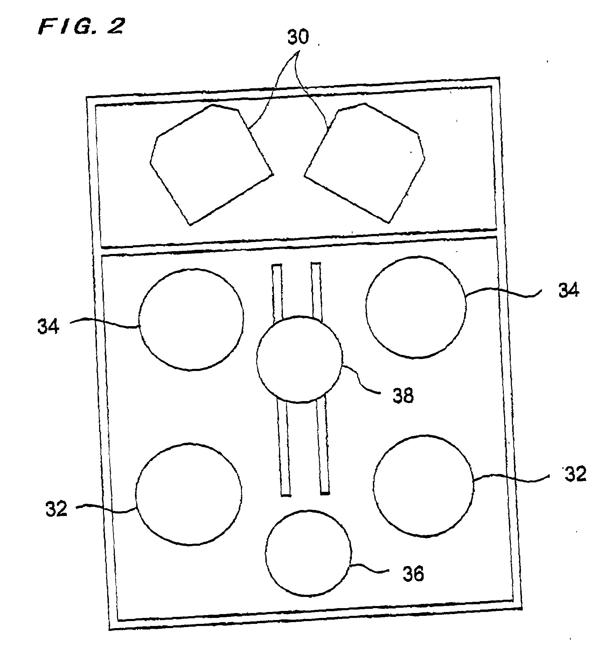

FIG. 2 is a plan view of an interconnects-forming apparatus in accordance with the present invention. The interconnects-forming apparatus comprises a facility which houses therein a pair of loading/unloading sections 30 for housing a plurality of substrates W therein, a pair of sputtering devices 32 for forming an underlying film, a pair of electroplating devices 34 for filling interconnects with a material, a cleaning device 36, and a transporting robot 38 for transporting the substrate W between the above devices.

The substrate W, which has the diffusion-inhibiting layer 16 (see FIG. 1A) formed on the surface, is taken out of the loading/unloading section 30 by the transporting robot 38, and transported to the sputtering device 32 for formation of underlying film, where sputtering is performed to form the underlying film 18 on the surface of the diffusion-inhibiting layer 16 (see FIG. 1B). As a material for the underlying film 18, as described above, when copper interconnects are to be formed, an alloy consisting of copper, i.e. the same material as the material for the interconnects, and a noble metal having a higher atomic weight than copper, e.g. palladium, silver, platinum or gold, is used. For example, a copper alloy containing 10 at % of palladium, Cu-Pd (10 at %), may be used. The substrate W is then transported to the cleaning device 36 for cleaning and drying the surface, and the cleaned substrate is transported to the electroplating device 34 for filling interconnect with material, where filling with copper is performed (see FIG. 1C). Thereafter, the substrate is cleaned and dried in the electroplating device 34, and the cleaned substrate is returned to the loading/unloading section 30.

Though the sputtering device 32 is used in this embodiment for formation of an underlying film, it is possible to use a CVD device instead of the sputtering device. Also, instead of the electroplating device 34 for filled with copper, an electroless plating device may be utilized.

### Example 1

As a substrate W as shown in FIG. 1A, a substrate composed of a semiconductor base 10 and an insulating film 12 of SiO₂ formed on the semiconductor base 10, in which recesses (holes) 14 having a diameter of 0.15 µm and a depth of 0.9 µm (aspect ratio: 6) are formed in the insulating film 12, was provided. A diffusion-inhibiting (barrier) layer 16 of TaN having a thickness of 30 nm was formed on the surface of the substrate by sputtering. An underlying film (seed layer) 18 composed of Cu-Pd (10 at %) alloy having a thickness of 90 nm was formed on the surface of the diffusion-inhibiting layer 16 by sputtering to prepare a test sample (see FIG. 1B). Thereafter, electrolytic copper plating was performed onto the surface of the sample to fill the recesses 14 with copper 20 (see FIG. 1C). The copper plating was performed using a plating liquid having the following composition under the following plating conditions:

| < Plating Liquid Composition > | |
|---|---|
| CuSO₄ · 5H₂O | 200 g/L |
| H₂SO₄ | 55 g/L |
| Cl⁻ | 60 mg/L |
| Additive | small amount |

| < Plating Conditions > | | |
|---|---|---|
| 2.5A/dm², | 2 min, | 25°C |

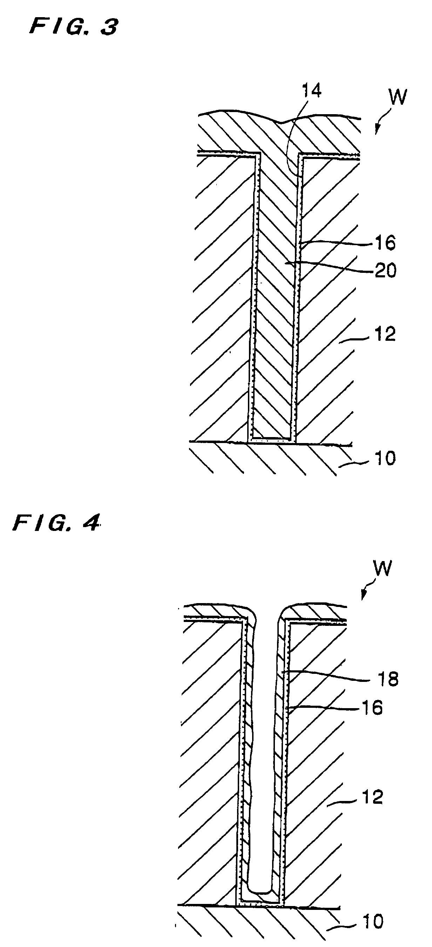

FIG. 3 shows an imitated diagram of an SEM (scanning electron microscope) photograph of a section of the sample after the plating treatment. As is apparent from FIG. 3, copper 20 is filled uniformly into the recess 14, and a defect-free, completely embedded copper interconnects are formed.

### Example 2

The same sample as used in Example 1, after formation of the underlying film (seed layer) 18 composed of Cu-Pd (10 at %) alloy having a thickness of 90 nm, was prepared. Electroless copper plating was performed onto the surface of the sample to effect reinforcement of the underlying film (seed layer) 18. The plating liquid composition and the plating conditions employed in the electroless copper plating are as follows:

| < Plating Liquid Composition > | |
|---|---|
| CuSO₄ · 5H₂O | 2.5 g/L |
| EDTA · 2Na | 20 g/L |
| NaOH | 4 g/L |
| HCHO (37%) | 5ml/L |

| < Plating Conditions > | |
|---|---|
| 65°C, | 60 sec |

FIG. 4 shows an imitated diagram of an SEM (scanning electron microscope) photograph of a section of the sample after the plating treatment. As is apparent from FIG. 4, a uniform reinforcement of the seed layer is effected to provide a defect-free seed layer 18.

### Comparative Example 1

As a substrate as shown in FIG. 8, a substrate composed of a semiconductor base 1 and an insulating film 2 of SiO₂ formed on the semiconductor base 1, in which recesses (holes) 5 having a diameter of 0.15 µm and a depth of 0.9 µm (aspect ratio: 6) are formed in the insulating film 2, was provided. A diffusion-inhibiting (barrier) layer 6 of TaN having a thickness of 30 nm was formed on the surface of the substrate by sputtering. An underlying film (seed layer) 8 composed of copper having a thickness of 90 nm was formed on the surface of the diffusion-inhibiting layer 6 by sputtering to prepare a test sample. Thereafter, electrolytic copper plating was performed onto the surface of the sample in the same manner as in Example 1 to filled the recesses 5 with copper 7.

FIG. 5 shows an imitated diagram of an SEM (scanning electron micrograph) photograph of a section of the sample after the plating treatment. As is apparent from FIG. 5, there is formed a void (lack of plating) C in the recess 5 beneath the embedded copper 7, which void occupies about 2/3 of the recess 5.

### Comparative Example 2

The same sample as used in Comparative Example 1, after formation of the underlying film (seed layer) 8 composed of copper having a thickness of 90 nm, was prepared. Electroless copper plating was performed onto the surface of the sample in the same manner as in Example 2 to effect reinforcement of the underlying film (seed layer) 8. FIG. 6 shows an imitated diagram of an SEM (scanning electron microscope) photograph of a section of the sample after the plating treatment. As is apparent from FIG. 6, there is a considerable lack of seed layer beneath the seed layer 8 formed in the recess (hole) 5. The lacking area occupies about 2/3 of the entire surface of the recess 5.

As described hereinabove, according to the present invention, embedded interconnects can be formed in a high yield using inexpensive wet plating, even when the interconnects are of a fine interconnection structure in which contact holes and via holes have a high aspect ratio.

Conventional underlying films (seed layers) hardly satisfy both the ① side coverage properties and ② bottom-up properties. This imposes a great deal of limitation on the composition of a plating liquid to be used for forming interconnects. In contrast, the underlying film (seed layer) of the present invention possesses good side coverage properties. Accordingly, the composition of a plating liquid to be used for forming interconnects can be optimized by paying attention only to the bottom-up growth of interconnects. This enables to increase the concentration of a carrier (brightener), which is a factor governing the bottom-up growth, in the plating liquid.

Although certain preferred embodiments of the present invention have been shown and described in detail, it should be understood that various changes and modifications may be made therein without departing from the scope of the appended claims.

According to its broadest aspect, the invention relates to a method for forming an interconnect by filling a conductive metal into a fine recess formed in a surface of a substrate, comprising: forming an underlying film on the surface of the substrate.

It should be noted that objects and advantages of the invention may be attained by means of compatible combination(s) particularly pointed out in the items of the following summary of the invention.

### SUMMARY OF THE INVENTION

1. A method for forming an interconnect by filling a conductive metal into a fine recess formed in a surface of a substrate, comprising:
   forming an underlying film on the surface of the substrate, said underlying film comprising at least two kinds of metals; and
   performing wet plating of said conductive metal onto the surface of said underlying film.
2. The method wherein said metals constituting said underlying film comprise a combination of a first metal, which is the same metal as said conductive metal, and a second metal, which is a noble metal having a larger atomic weight than said first metal.
3. The method wherein said first metal comprises gold, silver or copper.
4. The method wherein said first metal comprises copper, and said second metal comprises palladium, silver, platinum or gold.
5. The method wherein said underlying film is formed by sputtering or CVD.
6. A semiconductor device, comprising:
   an underlying film formed in a fine recess formed in a surface of a substrate, said underlying film comprising at least two kinds of metals; and
   an interconnect of a conductive metal, which is deposited onto said underlying film by performing wet plating.
7. The semiconductor device wherein said metals constituting said underlying film comprise a combination of a first metal, which is the same metal as said conductive metal, and a second metal, which is a noble metal having a larger atomic weight than said first metal.
8. The semiconductor device wherein the first metal comprises gold, silver or copper.
9. The semiconductor device wherein said first metal comprises copper, and said second metal comprises palladium, silver, platinum or gold.
10. The semiconductor device wherein said underlying film is formed by sputtering or CVD.
11. An apparatus for forming an interconnect, Comprising:
   a film-forming device for forming an underlying film on a surface of a substrate having a fine recess for an interconnect, said underlying film comprising at least two kinds of metals; and
   a plating device for performing wet plating of a conductive metal onto said underlying film, thereby filling said recess with said conductive metal.
12. The apparatus wherein said metals constituting said underlying film comprise a combination of a first metal, which is the same metal as said conductive metal, and a second metal, which is a noble metal having a larger atomic weight than said first metal.
13. The apparatus wherein said first metal comprises gold, silver or copper.
14. The apparatus wherein said first metal comprises copper, and said second metal comprises palladium, silver, platinum or gold.
15. The apparatus wherein said film-forming device comprises a sputtering device or a CVD device.

## Claims

1. A method for forming an interconnect by filling a conductive metal into a fine recess formed in a surface of a substrate, comprising:
forming an underlying film on the surface of the substrate, said underlying film comprising at least two kinds of metals; and
performing wet plating of said conductive metal onto the surface of said underlying film.

2. The method according to claim 1, wherein said metals constituting said underlying film comprise a combination of a first metal, which is the same metal as said conductive metal, and a second metal, which is a noble metal having a larger atomic weight than said first metal.

3. A semiconductor device, comprising:
an underlying film formed in a fine recess formed in a surface of a substrate, said underlying film comprising at least two kinds of metals; and
an interconnect of a conductive metal, which is deposited onto said underlying film by performing wet plating.

4. The semiconductor device according to any of the preceding claims, wherein said metals constituting said underlying film comprise a combination of a first metal, which is the same metal as said conductive metal, and a second metal, which is a noble metal having a larger atomic weight than said first metal.

5. An apparatus for forming an interconnect, comprising:
a film-forming device for forming an underlying film on a surface of a substrate having a fine recess for an interconnect, said underlying film comprising at least two kinds of metals; and
a plating device for performing wet plating of a conductive metal onto said underlying film, thereby filling said recess with said conductive metal.

6. The method or semiconductor device or apparatus according to any of the preceding claims, wherein said metals constituting said underlying film comprise a combination of a first metal, which is the same metal as said conductive metal, and a second metal, which is a noble metal having a larger atomic weight than said first metal.

7. The method or semiconductor device or apparatus according to any of the preceding claims, wherein said first metal comprises gold, silver or copper.

8. The method or semiconductor device or apparatus according to any of the preceding claims, wherein said first metal comprises copper, and said second metal comprises palladium, silver, platinum or gold.

9. The method or semiconductor device or apparatus according to any of the preceding claims, wherein said film-forming device comprises a sputtering device or a CVD device.

10. A method for forming an interconnect by filling a conductive metal into a fine recess formed in a surface of a substrate, comprising:
forming an underlying film on the surface of the substrate.
